# FASCICULE DE BREVET EUROPEEN

(11) **EP 1 037 265 B1**
(45) Date de publication et mention de la délivrance du brevet: **20.04.2005**
(21) Numéro de dépôt: 00410010.3
(22) Date de dépôt: 11.02.2000
(51) Int. Cl.: H01L 21/00, H01L 21/8242

(54) **Condensateur DRAM en forme de cuvette et son procédé de manufacture**
Schüsselförmiger DRAM-Kondensator und Verfahren zu seiner Herstellung
Cup-shaped DRAM capacitor and method of making the same

(30) Priorité: 12.02.1999 FR 9901892
(43) Date de publication de la demande: 20.09.2000
(73) Titulaire: STMicroelectronics S.A., 92120 Montrouge (FR); FRANCE TELECOM, 75015 Paris (FR)
(72) Inventeur: Ciavatti, Jérôme, Scottsdale, Arizona 85254 (US)
(74) Mandataire: de Beaumont, Michel

(56) Documents cités:
- US-A- 5 597 756
- PATENT ABSTRACTS OF JAPAN vol. 017, no. 657 (E-1470), 6 décembre 1993 (1993-12-06) & JP 05 218343 A (SONY CORP), 27 août 1993 (1993-08-27)
- PATENT ABSTRACTS OF JAPAN vol. 1998, no. 10, 31 août 1998 (1998-08-31) & JP 10 144882 A (OKI ELECTRIC IND CO LTD), 29 mai 1998 (1998-05-29) & US 5 939 747 A (OKI ELECTRIC INDUSTRY CO LTD) 17 août 1999 (1999-08-17)

## Description

La présente invention concerne de façon générale la formation d'un condensateur dans un circuit intégré. De tels condensateurs constituent, par exemple, l'élément de mémorisation d'une cellule mémoire dynamique à accès aléatoire (DRAM).

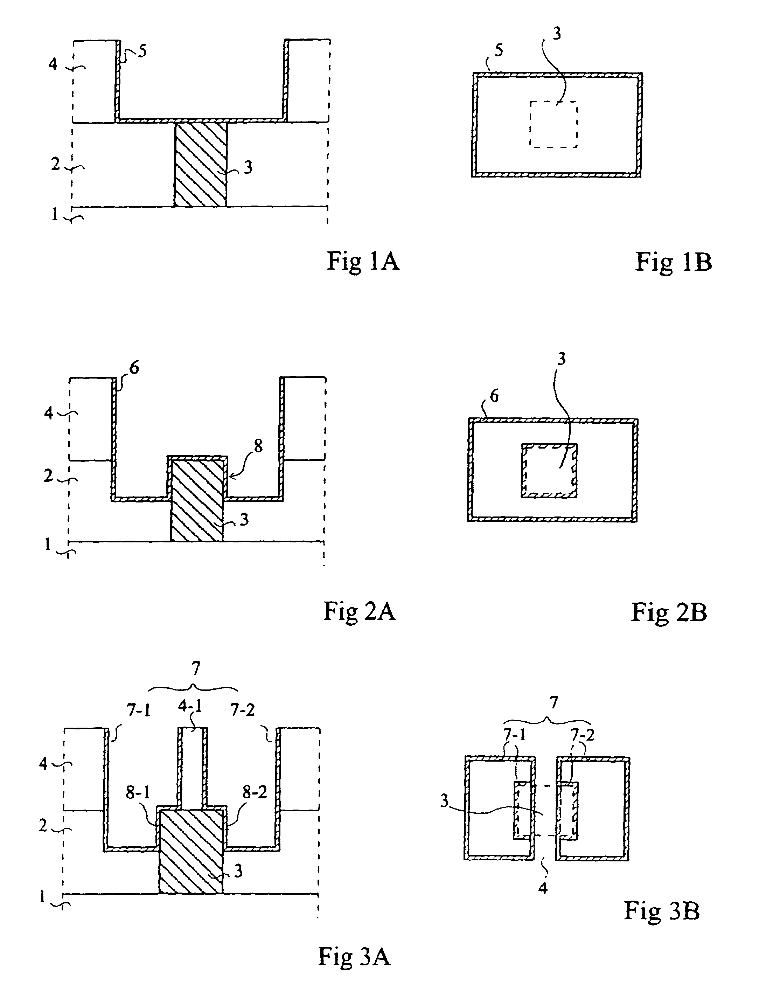

Les figures 1A et 1B illustrent schématiquement, en vue en coupe et en vue de dessus, respectivement, une partie d'une structure de cellule mémoire DRAM à un stade intermédiaire de sa formation dans un circuit intégré selon un procédé de fabrication classique. Chaque cellule DRAM comprend un transistor MOS de commande et un condensateur dont une électrode est en contact avec une région du substrat 1, typiquement une région de source/drain du transistor de commande. On suppose ici que les transistors MOS (non représentés) ont déjà été formés dans un substrat semiconducteur 1. On notera que par substrat on désigne autant une tranche de silicium uniformément dopée, que des zones épitaxiées et/ou spécifiquement dopées par diffusion/implantation formées sur ou dans un substrat massif. De telles tranches ou régions peuvent en outre avoir été préalablement siliciurées, au moins partiellement.

Une couche isolante 2, typiquement en oxyde de silicium, est formée sur le substrat 1. Cette couche 2 est munie de premières ouvertures qui ont typiquement en vue de dessus une forme carrée.

Chacune de ces ouvertures est remplie d'un plot conducteur 3, typiquement en tungstène ou en silicium polycristallin. Les plots 3 sont en contact avec des régions de source/drain (non représentées) des transistors de commande.

La structure est revêtue d'une couche isolante 4, typiquement en oxyde de silicium. Dans la couche 4 sont formées des deuxièmes ouvertures de façon à exposer la surface supérieure des plots 3. Les deuxièmes ouvertures ont typiquement en vue de dessus une forme rectangulaire.

Une couche conductrice 5 est formée sur les parois et les fonds des deuxièmes ouvertures. Cette couche 5 résulte par exemple d'un dépôt conforme de silicium polycristallin suivi d'une gravure mécano-chimique de la partie du dépôt de silicium polycristallin recouvrant la face supérieure de la couche 4.

On a formé ainsi une première électrode 5 d'un condensateur en contact électrique avec un substrat sous-jacent 1 par l'intermédiaire d'un plot conducteur 3. L'électrode 5 a une forme en "cuvette" à fond plat. En effet, l'électrode a en coupe (figure 1A) des parois verticales et un fond horizontal, et a en vue de dessus (figure 1B) sensiblement la forme d'un rectangle. A ce stade de fabrication, comme l'illustre la figure 1A, l'intérieur de la cuvette formée par l'électrode 5 est vide. Comme l'illustrent les figures 1A et 1B, le fond horizontal de l'électrode 5 est en contact sensiblement par son milieu avec le sommet du plot 3.

La structure ainsi obtenue et représentée aux figures 1A et 1B est ensuite complétée par le dépôt conforme d'un isolant (non représenté), puis par le dépôt et la gravure d'une couche conductrice (non représentée) constituant une deuxième électrode éventuellement commune à plusieurs condensateurs.

Pour améliorer les performances des mémoires intégrées, l'industrie électronique a aujourd'hui besoin de pouvoir augmenter la capacité des condensateurs constituant les points de mémorisation de cellules DRAM sans réduire la densité de la mémoire, ou d'augmenter la densité de la mémoire sans réduire la capacité des condensateurs.

Les figures du document Patent Abstract of Japan vol. 017, N° 657 (E-1470), 6 décembre 1993, & JP 05 218 343A, représentent un point mémoire (38, 40, 42) dont le fond est formé autour d'un plot de contact (34) dont la surface supérieure est en saillie par rapport à une couche isolante périphérique (32). Toutefois, la hauteur du plot qui déborde de la surface de la couche isolante est très faible.

Un objet de la présente invention est de proposer une nouvelle structure de condensateur intégré présentant une capacité plus élevée.

Un autre objet de la présente invention est de proposer une telle structure dans laquelle le contact entre le plot conducteur et la première électrode soit amélioré.

Pour atteindre ces objets, la présente invention prévoit un condensateur selon la revendication 1.

Selon un mode de réalisation de la présente invention, l'électrode est constituée de deux éléments distincts ayant chacun sensiblement une forme en cuvette, et étant chacun en contact électrique avec une partie du plot.

Selon un mode de réalisation de la présente invention, l'électrode est en silicium polycristallin.

Selon un mode de réalisation de la présente invention, le plot est en tungstène.

Selon un mode de réalisation de la présente invention, le plot est en silicium polycristallin.

Selon un mode de réalisation de la présente invention, la couche isolante est en oxyde de silicium.

La présente invention prévoit également un procédé de fabrication d'un condensateur selon la revendication 7, et selon la revendication 8.

Selon un mode de réalisation de la présente invention, les première et deuxième couches isolantes sont en oxyde de silicium.

Selon un mode de réalisation de la présente invention, la gravure de la deuxième couche conductrice est une gravure mécano-chimique.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B illustrent une structure classique de condensateurs intégrés ;
les figures 2A et 2B illustrent une nouvelle structure de condensateurs intégrés ; et
les figures 3A et 3B illustrent une variante de la structure représentée aux figures 2A et 2B.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

Les figures 2A et 2B illustrent schématiquement, en vue en coupe et en vue de dessus, respectivement, une partie d'une structure de cellule mémoire DRAM formée dans un circuit intégré selon un nouveau procédé de fabrication. Plus particulièrement, les figures 2A et 2B représentent une telle nouvelle structure à un stade intermédiaire de sa fabrication similaire à celui de la structure classique décrite précédemment en relation avec les figures 1A et 1B. Chaque cellule DRAM comprend un transistor MOS de commande et un condensateur dont une électrode est en contact avec une région du substrat 1, par exemple une région de source/drain du transistor de commande. On suppose de nouveau que des transistors MOS (non représentés) ont déjà été formés dans le substrat semiconducteur 1.

Le procédé commence par des étapes similaires à celles d'un procédé classique : formation de premières ouvertures dans une première couche isolante 2, de façon à exposer des régions choisies du substrat 1, par exemple des régions de source/drain (non représentées) des transistors de commande ; dépôt et gravure d'une première couche conductrice de façon à former dans les premières ouvertures des plots conducteurs 3 ; et dépôt d'une deuxième couche isolante 4.

Dans un mode de réalisation, la couche 2 est en oxyde de silicium et d'une épaisseur de 600 nm, les premières ouvertures étant, par exemple, en vue de dessus des carrés de 0,2 µm de côté. Les plots 3 sont remplis de tungstène ou de silicium polycristallin. La couche 4 est en oxyde de silicium et d'une épaisseur de 600 nm.

Selon l'invention, des deuxièmes ouvertures sont formées dans la deuxième couche isolante 4 et dans la première couche isolante 2 de façon à exposer la surface supérieure et une partie des parois verticales des plots 3.

Une caractéristique de la présente invention réside dans la formation de telles deuxièmes ouvertures plus profondes que des deuxièmes ouvertures classiques, faisant saillir les plots 3 par rapport à une partie gravée de la première couche isolante 2.

Pour ce faire, on utilise de préférence le même masque de gravure que dans un procédé classique. Les deuxièmes ouvertures ont alors, par exemple, en vue de dessus une forme rectangulaire classique. Un tel rectangle aura par exemple des dimensions de 0,8x0,5 µm.

Comme on l'a noté précédemment, les couches 2 et 4 sont en un même matériau isolant, de préférence en oxyde de silicium. Pour graver la couche 2 après la couche 4, il suffira d'augmenter le temps de gravure.

Dans un mode de réalisation (non représenté), l'interface entre les couches 2 et 4 est constituée d'une couche mince en un deuxième matériau isolant gravable sélectivement par rapport au premier matériau isolant et par rapport au matériau constituant le plot 3, par exemple en nitrure de silicium. Alors, la couche 4 puis la couche d'interface sont éliminées avant de graver de façon appropriée la couche 2.

Dans un mode de réalisation (non représenté), la structure de la couche 2 pourra être modifiée de façon à pouvoir contrôler de façon efficace l'arrêt de sa gravure. Par exemple, la couche 2 pourra être un tricouche constitué de parties inférieure (en contact avec le substrat 1) et supérieure en un premier matériau isolant, séparées par une couche mince en un deuxième matériau isolant. Le premier matériau isolant sera de préférence de l'oxyde de silicium. Le deuxième matériau isolant sera gravable sélectivement par rapport au premier matériau isolant et par rapport au matériau constituant le plot 3. Il s'agira, par exemple, de nitrure de silicium. Alors, les deuxièmes ouvertures seront formées dans la couche 2 de façon à exposer cette dernière couche mince en nitrure de silicium autour des plots 3.

Une couche conductrice 6 est formée sur les parois et le fond de chaque deuxième ouverture. Cette couche 6 résulte par exemple d'un dépôt conforme de silicium polycristallin suivi d'une gravure mécano-chimique de la partie du dépôt de silicium polycristallin recouvrant la face supérieure de la couche 4.

On a formé ainsi une première électrode 6 d'un condensateur en contact électrique avec un substrat sous-jacent 1 par l'intermédiaire d'un plot conducteur 3 en saillie par rapport à une couche isolante. Comme précédemment, l'électrode 6 a une forme sensiblement en "cuvette". Elle présente toutefois deux différences principales avec la structure antérieure. D'une part, les parois de la cuvette sont plus hautes que dans le cas de la figure 1A. D'autre part, le fond de la cuvette comprend un renfoncement 8 qui épouse le contour d'une partie du plot 3 en saillie par rapport à la couche isolante 2.

La structure ainsi obtenue et représentée aux figures 2A et 2B est ensuite complétée par le dépôt conforme d'un isolant (non représenté), puis par le dépôt et la gravure d'une nouvelle couche conductrice (non représentée) constituant une deuxième électrode éventuellement commune à plusieurs condensateurs.

Un avantage de la présente invention est d'augmenter la capacité des condensateurs intégrés. Comme cela ressort d'une comparaison des figures 1A et 2A, d'une part, et 1B et 2B, d'autre part, la surface de l'électrode 6 est supérieure à celle d'une électrode 5 classique du fait de l'augmentation de hauteur des bords de la cuvette et du fait de la présence du renfoncement 8. Plus précisément, cette surface est augmentée des parties verticales formées dans la couche 2. En considérant que les dimensions en vue de dessus de l'électrode 6 sont sensiblement 500x350 nm et en supposant que l'on a gravé la couche 2 sur une hauteur de sensiblement 300 nm, la surface de l'électrode 6 sera de l'ordre de 3,1 µm² au lieu de 1,96 µm² pour une électrode classique (5, figures 1A et 1B).

Un autre avantage de la présente invention est que cette augmentation de la capacité des condensateurs de cellules DRAM se fait sans modification de masque. Comme cela ressort de la description précédente et d'une comparaison des figures 1B et 2B, le masque utilisé pour la formation de deuxièmes ouvertures dans lesquelles sont formées les premières électrodes de condensateurs demeure inchangé par rapport à un procédé classique.

Un autre avantage de la présente invention est d'améliorer le contact entre chaque électrode de condensateur 6 et la région semiconductrice sous-jacente. En effet, selon la présente invention, le contact entre une électrode 6 et le plot 3 correspondant est amélioré du fait que ce contact correspond non seulement à la face supérieure du plot, mais aussi à une couronne supérieure du plot.

Les figures 3A et 3B illustrent une variante de la structure décrite précédemment en relation avec les figures 2A et 2B.

Selon cette variante, les deuxièmes ouvertures sont formées de la façon décrite précédemment en relation avec les figures 2A et 2B, dans la deuxième couche isolante 4 et dans la première couche isolante 2, mais de façon à laisser en place au niveau de chaque plot 3 une portion 4-1 de cette couche 4 séparant deux ouvertures indépendantes exposant chacune une partie du sommet du plot 3 de part et d'autre de la portion de la couche 4 laissée en place. Cette portion 4-1 est laissée en place sensiblement au centre du plot 3, de façon à exposer symétriquement des parties disjointes de sa surface supérieure.

Une deuxième couche conductrice 7 est formée sur les parois et le fond de chaque deuxième ouverture. Cette couche 7 résulte par exemple d'un dépôt conforme de silicium polycristallin suivi d'une gravure mécano-chimique de la partie du dépôt de silicium polycristallin recouvrant la face supérieure de la couche 4.

On a formé ainsi une première électrode 7 d'un condensateur en contact électrique avec un substrat sous-jacent 1, constituée de deux demi-électrodes indépendantes 7-1 et 7-2. Comme précédemment, chacune des demi-électrodes 7-1 et 7-2 a une structure sensiblement en cuvette. En vue en coupe (figure 3A), le fond de chaque demi-électrode 7-1, 7-2 comprend un renfoncement 8-1, 8-2 qui épouse le contour d'une partie du plot 3 en saillie par rapport à la couche isolante 2. En vue de dessus (figure 3B), chacune des demi-électrodes 7-1 et 7-2 a sensiblement la forme d'un rectangle.

On notera que la surface de chacune des demi-électrodes 7-1 et 7-2 est supérieure à la moitié de la surface d'une électrode classique telle qu'illustrée en figures 1A et 1B du fait de leur paroi verticale supplémentaire au-dessus du plot 3.

La structure ainsi obtenue et représentée aux figures 3A et 3B est ensuite complétée par le dépôt conforme d'un isolant (non représenté), puis par le dépôt et la gravure d'une nouvelle couche conductrice (non représentée) constituant une deuxième électrode éventuellement commune à plusieurs condensateurs.

Un avantage de cette variante est encore d'augmenter la capacité des condensateurs intégrés. Comme cela ressort d'une comparaison des figures 1A ou 2A et 3A, d'une part, et 1B ou 2B et 3B, d'autre part, la surface de l'électrode 7 est accrue du fait de la mise en parallèle de deux demi-électrodes 7-1, 7-2 ayant chacune une surface supérieure à la moitié de la surface d'une électrode classique. En considérant comme unitaire la capacité d'un condensateur classique à première électrode en cuvette simple 5 telle qu'illustrée aux figures 1A et 1B, en considérant à titre d'exemple que les dimensions en vue de dessus de chacune des demi-électrodes 7-1, 7-2 sont sensiblement 500x350 nm et que la largeur de la partie de la couche 4 maintenue au-dessus du plot 3 pour séparer les demi-électrodes 7-1, 7-2 est de l'ordre de 150 nm, et en supposant que l'on a gravé la couche 2 sur une hauteur de sensiblement 300 nm, la surface d'un nouveau condensateur à première électrode en cuvette double selon cette variante de l'invention sera de l'ordre de 3,4 µm².

Bien entendu, la présente invention est susceptible de diverses variantes et modifications qui apparaîtront à l'homme de l'art. En particulier, la profondeur des deuxièmes ouvertures dans la première couche isolante 2 peut être modifiée facilement en contrôlant par des techniques classiques la gravure de la couche 2 (temps de gravure et/ou formation d'une couche d'arrêt de gravure en nitrure de silicium). Par ailleurs, après la gravure de la première électrode 6 et avant le dépôt conforme de l'isolant (non représenté) destiné à constituer le diélectrique du condensateur, la deuxième couche isolante 4 peut être éliminée au moins partiellement afin d'augmenter encore la surface de l'électrode, et donc la capacité, à l'extérieur de la cuvette, le long des parois verticales. De plus, la présente invention s'applique également à l'augmentation de la capacité de tout type de condensateurs intégrés autres que des éléments de mémorisation de cellules DRAM.

## Revendications

1. Structure comprenant un plot conducteur (3), une couche isolante (2) et un condensateur dont une électrode (6 ; 7) présente une forme générale en cuvette, comportant un fond généralement horizontal et des parois verticales, l'électode étant en contact électrique par son fond avec le plot conducteur (3), ledit plot débordant par rapport à la surface supérieure de la couche isolante (2) et ledit fond comportant un renfoncement (8 ; 8-1, 8-2) complémentaire de la partie en saillie du plot, les parois verticales s'étendant vers le haut au-delà de la partie en saillie du plot, **caractérisée en ce que** la hauteur dudit plot déborde de la couche isolante de façon à augmenter substantiellement la capacité du condensateur par rapport à un condensateur dans une structure où le plot ne déborde pas par rapport à la surface de la couche isolante et le fond de l'électrode ne possède pas un renfoncement.

2. Structure selon la revendication 1, **caractérisée en ce que** ladite électrode (7) est constituée de deux éléments distincts (7-1, 7-2) ayant chacun sensiblement une forme en cuvette, et étant chacun en contact électrique avec une partie du plot.

3. Structure selon la revendication 1 ou 2, **caractérisée en ce que** l'électrode (6) est en silicium polycristallin.

4. Structure selon la revendication 1 ou 2, **caractérisée en ce que** le plot (3) est en tungstène.

5. Structure selon la revendication 1 ou 2, **caractérisée en ce que** le plot (3) est en silicium polycristallin.

6. Structure selon la revendication 1 ou 2, **caractérisée en ce que** la couche isolante (2) est en oxyde de silicium.

7. Procédé de fabrication d'une structure selon la revendication 1, **caractérisé en ce qu'**il comprend les étapes suivantes :
former dans une première couche isolante (2) sur un substrat semiconducteur (1) une première ouverture de façon à exposer une région choisie du substrat ;
déposer et graver une première couche conductrice (3) de façon à former dans la première ouverture un plot conducteur (3) ;
déposer une deuxième couche isolante (4) ;
former dans la deuxième couche isolante et la première couche isolante une deuxième ouverture, de façon que le plot fasse saillie par rapport à la surface la plus profonde de la deuxième ouverture ;
déposer de façon conforme une deuxième couche conductrice (6) ;
graver la deuxième couche conductrice de façon à éliminer ses parties horizontales reposant sur la deuxième couche isolante ;
déposer de façon conforme un diélectrique mince ; et
déposer et graver une troisième couche conductrice.

8. Procédé de formation d'une structure selon la revendication 2, **caractérisé en ce qu'**il comprend les étapes suivantes :
former dans une première couche isolante (2) sur un substrat semiconducteur (1) une première ouverture de façon à exposer une région choisie du substrat ;
déposer et graver une première couche conductrice (3) de façon à former dans la première ouverture un plot conducteur (3) ;
déposer une deuxième couche isolante (4) ;
former dans la deuxième couche isolante et la première couche isolante des deuxièmes ouvertures adjacentes séparées par une bande isolante (4-1) plus étroite que le plot et sensiblement centrée sur le plot, les deuxièmes ouvertures étant formées de façon que le plot saille par rapport à là surface la plus profonde des deuxièmes ouvertures ;
déposer de façon conforme une deuxième couche conductrice (7) ;
graver la deuxième couche conductrice de façon à éliminer ses parties horizontales reposant sur la deuxième couche isolante ;
déposer de façon conforme un diélectrique mince ; et
déposer et graver une troisième couche conductrice.

9. Procédé selon la revendication 7 ou 8, **caractérisé en ce que** les première et deuxième couches isolantes (2, 4) sont en oxyde de silicium.

10. Procédé selon la revendication 7 ou 8, **caractérisé en ce que** la gravure de la deuxième couche conductrice est une gravure mécano-chimique.

## Patentansprüche

1. Eine Struktur mit einem leitenden Pad bzw. Flächenelement (3), einer isolierenden Schicht (2) und einem Kondensator mit einer Elektrode (6; 7), die im Allgemeinen schalenförmig ist und einen im Allgemeinen horizontalen Boden und vertikale Wände umfasst, wobei die Elektrode über ihren Boden mit dem leitenden Pad (3) in elektrischen Kontakt steht, wobei sich das Pad über die Oberseite der isolierenden Schicht (2) hinaus erstreckt und wobei der Boden eine Ausnehmung (8; 8-1, 8-2) aufweist, die komplementär zu dem vorstehenden Padteil ist, **dadurch gekennzeichnet**, das die Höhe, die das Pad über die isolierende Schicht hinaus vorsteht derart ist, dass sie die Kapazität des Kondensators wesentlich gegenüber einem Kondensator, bei dem das Pad nicht bezüglich der Oberfläche der isolierenden Schicht vorsteht, erhöht, und der Boden der Elektrode keine Ausnehmung besitzt.

2. Struktur nach Anspruch 1, wobei die Elektrode (7) aus zwei bestimmten bzw. getrennten Elementen (7-1, 7-2) ausgebildet ist, die jeweils im wesentlichen schalenförmig sind, und die jeweils in elektrischen Kontakt mit einem Teil des Pads stehen.

3. Struktur nach Anspruch 1 oder 2, wobei die Elektrode (6) aus Polysilizium hergestellt ist.

4. Struktur nach Anspruch 1 oder 2, wobei das Pad (3) aus Wolfram hergestellt ist.

5. Struktur nach Anspruch 1 oder 2, wobei das Pad (3) aus Polysilizium hergestellt ist.

6. Struktur nach Anspruch 1 oder 2, wobei die isolierende Schicht (2) aus Siliziumoxid hergestellt ist.

7. Verfahren zur Herstellung der Struktur nach Anspruch 1, **dadurch gekennzeichnet, dass** das Verfahren die folgenden Schritte aufweist:
Ausbilden einer ersten Öffnung in einer sich auf einem Halbleitersubstrat (1) befindlichen isolierenden Schicht (2), um einen ausgewählten Bereich des Substrats freizulegen;
Abscheiden und Ätzen einer ersten leitenden Schicht (3) zur Ausbildung eines leitenden Flächenelements bzw. Pads (3) in der ersten Öffnung;
Abscheiden einer zweiten isolierenden Schicht (4);
Ausbilden einer zweiten Öffnung in einer zweiten isolierenden Schicht und der ersten isolierenden Schicht, so dass das Pad von der tiefsten Oberfläche von der zweiten Öffnung vorsteht;
Angepasstes Abscheiden einer zweiten leitenden Schicht (6);
Ätzen der zweiten leitenden Schicht zum Entfernen ihrer horizontalen Teile, die auf der zweiten isolierenden Schicht ruhen;
Angepasstes bzw. konformes Abscheiden eines dünnen dielektrischen Materials; und
Abscheiden und Ätzen einer dritten leitenden Schicht.

8. Verfahren zur Herstellung der Struktur nach Anspruch 2, **dadurch gekennzeichnet, dass** das Verfahren folgende Schritte aufweist:
Ausbilden einer ersten Öffnung in einer sich auf einem Halbleitersubstrat (1) befindlichen ersten isolierenden Schicht (2), um einen ausgewählten Bereich des Substrats freizulegen;
Abscheiden und Ätzen einer ersten leitenden Schicht (3) zum Bilden eines leitenden Pads bzw. Flächenelements (3) in der ersten Öffnung;
Abscheiden einer zweiten isolierenden Schicht (4);
Ausbilden zweiter benachbarter Öffnungen in der zweiten isolierenden Schicht und der ersten isolierenden Schicht, die durch einen isolierenden Streifen (4-1) voneinander getrennt sind, der schmaler ist, als das Pad und im wesentlichen an dem Pad zentriert ist, wobei die zweiten Öffnungen so ausgebildet sind, dass das Pad bezüglich der tiefsten Oberfläche der zweiten Öffnungen vorsteht;
Angepasstes bzw. konformes Abscheiden einer zweiten leitenden Schicht (7);
Ätzen der zweiten leitenden Schicht um ihre horizontalen Abschnitte, die auf der zweiten isolierenden Schicht ruhen zu entfernen;
Angepasstes bzw. konformes Abscheiden eines dünnen dielektrischen Materials; und
Abscheiden und Ätzen einer dritten leitenden Schicht.

9. Verfahren nach Anspruch 7 oder 8, wobei die ersten und zweiten leitenden Schichten (2, 4) aus Siliziumoxid hergestellt sind.

10. Verfahren nach Anspruch 7 oder 8, wobei das Ätzen der zweiten leitenden Schicht ein chemisch-mechanisches Ätzen ist.

## Claims

1. A structure including a conductive pad (3), an insulating layer (2) and a capacitor having an electrode (6; 7) which is generally cup-shaped, including a generally horizontal bottom and vertical walls, the electrode being in electric contact by its bottom with the conductive pad (3), said pad extending beyond the upper surface of the insulating layer (2) and said bottom including a recess (8; 8-1, 8-2) complementary to the protruding pad portion, **characterized in that** the height of said pad protrudes from the insulating layer, so as to substantially increase the capacitance of the capacitor with respect to a capacitor wherein the pad does not protrude with respect to the surface of the insulating layer and the bottom of the electrode has no recess.

2. The structure of claim 1, wherein said electrode (7) is formed of two distinct elements (7-1, 7-2) each being substantially cup-shaped, and each being in electric contact with a portion of the pad.

3. The structure of claim 1 or 2, wherein the electrode (6) is made of polysilicon.

4. The structure of claim 1 or 2, wherein the pad (3) is made of tungsten.

5. The structure of claim 1 or 2, wherein the pad (3) is made of polysilicon.

6. The structure of claim 1 or 2, wherein the insulating layer (2) is made of silicon oxide.

7. A method of manufacturing the structure of claim 1, **characterized in that** it includes the steps of:
forming, in a first insulating layer (2) on a semiconductor substrate (1), a first opening to expose a selected region of the substrate;
depositing and etching a first conductive layer (3) to form a conductive pad (3) in the first opening;
depositing a second insulating layer (4);
forming, in the second insulating layer and the first insulating layer, a second opening, so that the pad protrudes from the deepest surface of the second opening;
conformally depositing a second conductive layer (6);
etching the second conductive layer to remove its horizontal portions resting on the second insulating layer;
conformally depositing a thin dielectric; and
depositing and etching a third conductive layer.

8. A method of manufacturing the structure of claim 2, **characterized in that** it includes the steps of:
forming, in a first insulating layer (2) on a semiconductor substrate (1) a first opening to expose a selected region of the substrate;
depositing and etching a first conductive layer (3) to form a conductive pad (3) in the first opening;
depositing a second insulating layer (4);
forming, in the second insulating layer and the first insulating layer, second adjacent openings separated by an insulating strip (4-1) narrower than the pad and substantially centered on the pad; the second openings being formed so that the pad protrudes with respect to the deepest surface of the second openings;
conformally depositing a second conductive layer (7);
etching the second conductive layer to remove its horizontal portions resting on the second insulating layer;
conformally depositing a thin dielectric; and
depositing and etching a third conductive layer.

9. The method of claim 7 or 8, wherein the first and second conductive layers (2, 4) are made of silicon oxide.

10. The method of claim 7 or 8, wherein the etching of the second conductive layer is a chem-mech etching.
